# EUROPÄISCHE PATENTSCHRIFT

(11) **EP 3 921 718 B1**
(45) Veröffentlichungstag und Bekanntmachung des Hinweises auf die Patenterteilung: **01.11.2023**
(21) Anmeldenummer: 20701183.4
(22) Anmeldetag: 17.01.2020
(51) Int. Cl.: G06F 1/20, H01L 23/367, H05K 7/20

(54) **COMPUTERSYSTEM UND WÄRMELEITKÖRPER**
COMPUTER SYSTEM AND THERMALLY CONDUCTIVE BODY
SYSTÈME D'ORDINATEUR ET CORPS THERMOCONDUCTEUR

(30) Priorität: 07.02.2019 DE 102019103071
(43) Veröffentlichungstag der Anmeldung: 15.12.2021
(73) Patentinhaber: Fujitsu Client Computing Limited, Kawasaki, Kanagawa 211-0058 (JP)
(72) Erfinder: NEUKAM, Wilhelm, 80807 München (DE)
(74) Vertreter: Epping - Hermann - Fischer
(86) Internationale Anmeldenummer: PCT/EP2020/051161
(87) Internationale Veröffentlichungsnummer: WO 2020/160889

(56) Entgegenhaltungen:
- EP-A2- 2 506 113
- WO-A1-2012/139935
- DE-A1-102004 035 810
- DE-A1-102011 007 171

## Beschreibung

Die Erfindung betrifft ein Computersystem, welches Computergehäuse mit mehreren Seitenwänden aufweist. In dem Computergehäuse ist eine Hauptplatine mit zumindest einer wärmeerzeugenden Komponente angeordnet. Die Erfindung betrifft darüber hinaus einen Wärmeleitkörper für ein solches Computersystem.

Computersysteme erzeugen in ihrem Betrieb eine verhältnismäßig große Menge an Abwärme, die zum sicheren Betrieb des Computersystems abgeführt werden muss. Im Besonderen müssen thermisch kritische Bauelemente, wie etwa ein oder mehrere Prozessoren des Computersystems, in besonderem Maße gekühlt werden. Die wärmeerzeugenden Komponenten sind typischerweise direkt oder mittelbar mit einer Hauptplatine des Computersystems verbunden. Eine technische Herausforderung liegt darin, gerade bei der zunehmenden Miniaturisierung und kompakteren Bauweise von Computersystemen eine ausreichende Kühlung der Komponenten herbeizuführen.

Die EP 2 506 113 A2 offenbart eine Mediengerät, das die Form einer Set-Top-Box (STB) annehmen kann. Es umfasst ein Gehäuse oder Chassis, das eine Schnittstellenplatte mit selektiv konfigurierten Bereichen enthält, die mit auf einer gedruckten Leiterplatte montierten Komponenten zusammenwirken. Die selektiv konfigurierten Bereiche der Schnittstellenplatte können vorteilhafterweise den gewünschten Abstand oder Kontakt zwischen der Schnittstellenplatte und einer oder mehreren der Komponenten herstellen. Darüber hinaus können die selektiv konfigurierten Bereiche der Schnittstellenplatte so angeordnet sein, dass sie eine strukturelle Unterstützung für eine obere Platte des Gehäuses bieten und gleichzeitig spezifische Wärmeübertragungswege zwischen den Komponenten und dem Gehäuse bereitstellen. Auf diese Weise kann die Zwischenplatte mit einer gewünschten thermischen Masse und/oder einer gewünschten Wärmeleitfähigkeit in bestimmten Bereichen der Zwischenplatte durch Variieren der Eigenschaften der Zwischenplatte, zu denen unter anderem die Plattendicke und das Material gehören können, kontrolliert gestaltet werden.

Die DE 10 2004 035810 A1 betrifft ein Kondensatormodul mit einer Vielzahl von Kondensatoren, die in einem Gehäuse angeordnet sind, wobei eine mit einem Kondensator in Verbindung stehende Wärmekontaktfläche mittels einer Masse mit einer Gehäusefläche verbunden ist. Das Modul hat den Vorteil, dass die Ableitung der Verlustwärme an die Umgebung verbessert ist.

Die WO 2012/139935 A1 betrifft eine Kühlvorrichtung für ein Elektronikmodul eines Haushaltsgeräts, welche einen Grundkörper aufweist, dadurch gekennzeichnet, dass auf dem Grundkörper zumindest bereichsweise ein Wärme ableitendes Grafitmaterial ausgebildet ist. Die Erfindung betrifft auch eine Baugruppe mit einer solchen Kühlvorrichtung und ein Haushaltsgerät zur Pflege von Wäschestücken mit einer Kühlvorrichtung.

Eine Aufgabe, welche der Erfindung zugrunde liegt, ist es, ein Konzept für ein Computersystem zu beschreiben, welches eine besonders effiziente und effektive Kühlung einer wärmeerzeugenden Komponente eines Computersystems ermöglicht.

Gemäß einem Aspekt wird ein Computersystem offenbart, welches ein Computergehäuse mit mehreren Seitenwänden aufweist. Im Inneren des Computergehäuses ist eine Hauptplatine angeordnet, auf der zumindest eine wärmeerzeugende Komponente angeordnet ist. Eine Seitenwand des Computersystems, die der wärmeerzeugenden Komponente zugewandt ist, weist einen Wärmeleitkörper auf, der in Richtung der wärmeerzeugenden Komponente vorspringt. Der vorspringende Wärmeleitkörper ist integraler Teil der Wärmeverteilplatte und mit dieser einstückig ausgebildet, wobei die Wärmeverteilplatte an der entsprechenden Seitenwand angeordnet ist, und wobei der Wärmeleitkörper und die Wärmeverteilplatte als Aluminiumdruckgussbauteil ausgebildet sind. Der Wärmeleitkörper ist ausgebildet, mittels Wärmeleitung Wärmeenergie der wärmeerzeugenden Komponente, die während eines bestimmungsgemäßen Betriebs entsteht, aufzunehmen und mittels Wärmeleitung in die entsprechende Seitenwand abzuführen.

Das Computersystem ermöglicht eine besonders effiziente und effektive Wärmeabfuhr und damit Kühlung der wärmeerzeugenden Komponente, in dem ein Wärmeleitkörper an einer Seitenwand vorgesehen ist, der sich in Richtung der wärmeerzeugenden Komponente erstreckt. Mit anderen Worten steht der Wärmeleitkörper von der Seitenwand in Richtung der wärmeerzeugenden Komponente ab. Dadurch ist es möglich, den Wärmeleitkörper in unmittelbarer Nähe der wärmeerzeugenden Komponente zu bringen und über einen direkten oder indirekten Kontakt mit der wärmeerzeugenden Komponente die Wärme effizient und effektiv abzuführen. Dadurch, dass der Wärmeleitkörper in einem Druckgussverfahren hergestellt ist, können besonders gute thermische Eigenschaften erreicht werden. Insbesondere kann der Wärmeleitkörper besonders dick und massiv hergestellt werden. Darüber hinaus wird ermöglicht, dass der Wärmeleitkörper besonders exakt an einer erforderlichen Geometrie der wärmeerzeugenden Komponente und weiterer Komponenten der Hauptplatine sowie der Hauptplatine selbst angepasst werden kann. Der ohnehin spärlich bemessene Raum im Inneren des Computergehäuses kann somit effizient und zielgerichtet zum Abführen der Wärme genutzt werden. Insbesondere ermöglicht der Wärmeleitkörper eine Wärmeabfuhr in den Bereichen der Hauptplatine beziehungsweise des Computergehäuses, die nicht oder nur sehr schwach durch Luftströmungen gekühlt werden können.

Der Begriff "Wärmeleitung" bedeutet im Kontext der vorliegenden Offenbarung, dass eine Wärmeenergie durch eine thermisch-mechanische Kopplung übertragen wird. Der Wärmeleitkörper steht somit direkt mit der Seitenwand in Kontakt. Zudem kontaktiert der Wärmeleitkörper die wärmeerzeugende Komponente direkt oder über ein Zwischenelement mittelbar.

Der Wärmeleitkörper kann Teil der Seitenwand sein, oder aber auch als eine separate Komponente in direktem Kontakt mit der Seitenwand des Computergehäuses stehen. Das Computergehäuse, zumindest die entsprechende Seitenwand, ist aus einem wärmeleitenden Metallwerkstoff hergestellt. Hierbei bietet sich beispielsweise Aluminium an.

Erfindungsgemäß ist der vorspringende Wärmeleitkörper Teil einer Wärmeverteilplatte, die an der entsprechenden Seitenwand angeordnet ist. Mit anderen Worten wird eine separate Wärmeverteilplatte mit dem Wärmeleitkörper an der Seitenwand angeordnet. Der Wärmeleitkörper ist somit integraler Bestandteil der Wärmeverteilplatte. Mit anderen Worten ist die Wärmeverteilplatte einstückig mit dem Wärmeleitkörper ausgebildet. Somit handelt es sich bei der Wärmeverteilplatte mit dem Wärmeleitkörper um ein Druckgussbauteil, wodurch besonders hohe Wandstärken erreicht werden können und insbesondere der Wärmeleitkörper sehr exakt an die erforderliche Geometrie der Hauptplatine und der wärmeerzeugenden Komponente angepasst werden kann. Insbesondere können weitaus dickere Wandstärken im Vergleich zu einer lediglich aus einem Blech hergestellten Wärmeverteilplatte hergestellt werden. Darüber hinaus ist der Wärmeleitkörper typischerweise massiv ausgebildet, das heißt aus Vollmaterial, was wiederum einen erheblichen Vorteil im Vergleich zu einem Blechkörper darstellt, da dieser zwischen der Seitenwand und der Kontaktfläche nicht einschließen würde, die als Isolator wirken würde.

Erfindungsgemäß sind der Wärmeleitkörper und die Wärmeverteilplatte als Aluminiumdruckgussbauteil ausgebildet. Dies trägt besonders dazu bei, die vorgenannten Vorteile und Funktionen zu erzielen. Es wird eine besonders leichte Platte mit Wärmeleitkörper ermöglicht, die ideale Eigenschaften für den Wärmetransport hat. Diese Platte lässt sich besonders gut fertigen und exakt an Geometrien des Computersystems und dessen Komponenten im Inneren anpassen. Der Erfinder hat erkannt, dass gerade die Verwendung eines Aluminiumdruckgussbauteils die vorgenannten Vorteile und Funktionen besonders gut ermöglicht.

Gemäß einer Ausführungsform ist der Wärmeleitkörper in direktem Kontakt mit der wärmeerzeugenden Komponente. Dadurch kann ein direkter Wärmetransfer mittels Wärmeleitung von der wärmeerzeugenden Komponente auf den Wärmeleitkörper stattfinden.

Gemäß einer Ausführungsform ist zwischen dem Wärmeleitkörper und der wärmeerzeugenden Komponente ein Spalt ausgebildet, in welchem ein wärmeleitendes Element angeordnet ist, sodass der Wärmeleitkörper mittels des wärmeleitenden Elements mittelbar mit der wärmeerzeugenden Komponente in Kontakt steht. Bei dieser Ausführungsform handelt es sich um einen indirekten Kontakt des Wärmeleitkörpers mit der wärmeerzeugenden Komponente. Der Wärmeleitkörper ist leicht beabstandet von der wärmeerzeugenden Komponente. Um eine Wärmeleitung herbeizuführen, ist in den Spalt das wärmeleitende Element eingebracht, welches in direktem Kontakt mit dem Wärmeleitkörper und der wärmeerzeugenden Komponente steht. Bei diesem Element handelt es sich beispielsweise um ein sogenanntes thermisches Pad oder Wärmleitpad. Dadurch können besonders gut Fertigungstoleranzen ausgeglichen werden. Weiterhin trägt das wärmeleitende Element zu einer besonders guten Wärmeübertragung bei. Das wärmeleitende Element kann entsprechend der Ausbildung des Spaltes besonders dünn ausgebildet sein, wodurch die Effizienz bei der Wärmeübertragung erhöht wird. In Kombination mit dem Wärmeleitkörper wird ein besonders effizienter Wärmeübergang ermöglicht im Vergleich zu Systemen, bei welchen lediglich ein wärmeleitendes Element eingesetzt wird, welches dann entsprechend dick ausgeformt sein müsste. Ein typisches Spaltmaß liegt im Bereich von 0,5 mm bis 1,0 mm.

Gemäß einer Ausführungsform weist der Wärmeleitkörper im Vergleich zu der Seitenwand eine größere Wandstärke auf. Beispielsweise ist der Wärmeleitkörper quaderförmig beziehungsweise flächig ausgeprägt. Dadurch wird zu einer Massenanhäufung beigetragen, sodass zusätzlich thermische Energie aufgenommen werden kann und so das Computersystem besonders effizient und schnell gekühlt werden kann.

Gemäß einer Ausführungsform ist der Wärmeleitkörper hinsichtlich einer Formgebung an die wärmeerzeugende Komponente angepasst. Dadurch wird zu einer besonders effizienten Wärmeabfuhr beigetragen, indem beispielsweise ein besonders großflächiger Kontakt mit der wärmeerzeugenden Komponente hergestellt wird, entweder direkt oder mittelbar mittels des zuvor erwähnten wärmeleitenden Elements. Beispielsweise ist eine der wärmeerzeugenden Komponenten zugewandte Kontaktfläche des Wärmeleitkörpers hinsichtlich der Formgebung an eine Gegenkontaktfläche der wärmeerzeugenden Komponente angepasst.

Gemäß einer Ausführungsform ist die Hauptplatine an der Seitenwand des Computersystems angeordnet. Zwischen der Seitenwand und der Hauptplatine ist ein Spalt ausgebildet, in welchem die wärmeerzeugende Komponente angeordnet ist. Mit anderen Worten ist die wärmeerzeugende Komponente an einer Unterseite der Hauptplatine angeordnet, die im Regelfall nur leicht beabstandet, das heißt besonders nah, an einer Seitenwand angeordnet ist. In diesem Bereich strömt im Regelfall keine Kühlluft, sodass eine Kühlung in diesem Bereich im Regelfall ungenügend ist. Durch die erfindungsgemäße Anordnung eines Wärmeleitkörpers wird eine verbesserte Abführung von Wärme in diesem Bereich erreicht.

An dieser Stelle sei erwähnt, dass die Seitenwand und/oder die Wärmeverteilplatte mehrere Wärmeleitkörper aufweisen können, die ausgebildet sind, die während eines bestimmungsgemäßen Betriebs entstehende Wärme von weiteren wärmeerzeugenden Komponenten der Hauptplatine abzuführen. Es gilt im Wesentlichen das oben Gesagte analog.

Gemäß einer Ausführungsform erstreckt sich die Wärmeverteilplatte über mehr als die Hälfte der Fläche der Seitenwand. Dies trägt zu einer besonders effizienten und schnellen Wärmeabfuhr über die Gehäusewand bei.

Gemäß einem weiteren Aspekt wird ein Wärmeleitkörper für ein oben beschriebenes Computersystem offenbart. Der Wärmeleitkörper ist ausgebildet, an einer Seitenwand eines Computergehäuses des Computersystems angeordnet zu werden, sodass der Wärmeleitkörper in Richtung einer wärmeerzeugenden Komponente einer Hauptplatine des Computersystems vorspringt. Der Wärmeleitkörper ist in einem Druckgussverfahren hergestellt. Der Wärmeleitkörper ist ausgebildet, Wärme der wärmeerzeugenden Komponente, die während eines bestimmungsgemäßen Betriebs des Computersystems entsteht, mittels Wärmeleitung in die Seitenwand abzuführen.

Der Wärmeleitkörper ermöglicht im Wesentlichen die vorgenannten Vorteile und Funktionen.

Weitere Vorteile und Ausgestaltungen sind in der nachfolgenden Beschreibung eines Ausführungsbeispiels unter Zuhilfenahme der angehängten Figuren offenbart. Gleiche oder funktionsgleiche Elemente sind mit gleichen Bezugszeichen versehen.

In den Figuren zeigen:
Figur 1 eine schematische, perspektivische Ansicht eines Computersystems,
Figur 2 eine perspektivische Ansicht eines Teils des Computergehäuses des Computersystems,
Figur 3 eine perspektivische Ansicht einer Wärmeverteilplatte mit Wärmeleitkörper gemäß einem Ausführungsbeispiel der Erfindung, und
Figur 4 eine schematische, perspektivische Ansicht eines Teils des Computergehäuses des Computersystems mit der Wärmeverteilplatte gemäß Figur 3.

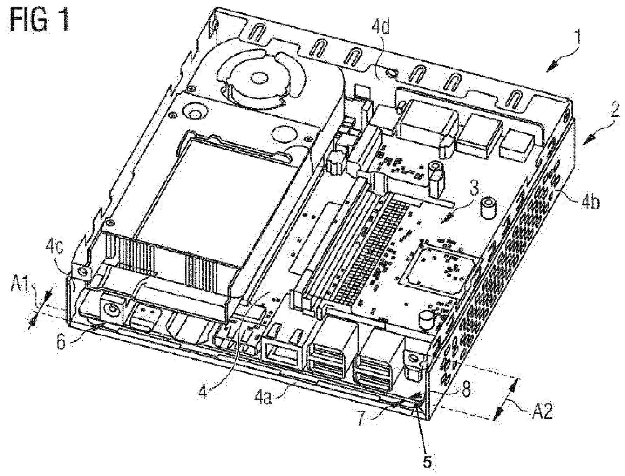

Figur 1 zeigt ein exemplarisches Computersystem 1, welches teilweise geöffnet ist, um den Blick ins Innere zu gewähren. Bei dem Computersystem 1 handelt es sich um ein kompaktes System, etwa einen sogenannten Mini-PC, welches über eine Vielzahl von Schnittstellen zum Verbinden von Peripheriegeräten wie Bildschirm, Maus, oder aufweist.

Das Computersystem 1 weist ein Computergehäuse 2 auf, welches nur zum Teil dargestellt ist. Insbesondere ist auf den Gehäusedeckel aus Gründen der Übersichtlichkeit verzichtet. Das Computergehäuse 2 weist mehrere Seitenwände 4 auf, die einzeln die Bezugszeichen 4a, 4b, 4c, 4d tragen. Bei der ersten Seitenwand 4a handelt es sich beispielsweise um eine Bodenwand.

Weiterhin weist das Computersystem 1 im Inneren 3 des Computergehäuses 2 eine Hauptplatine 5 auf, die an der Bodenwand 4a angeordnet ist. Zwischen der Bodenwand 4a und der Hauptplatine 5 ist ein Spalt 6 ausgebildet. Die Hauptplatine 5 ist damit nahe an der Bodenwand 4a angeordnet und deutlich weiter beanstandet von der gegenüberliegenden, nicht gezeigten, Deckelwand. Mit anderen Worten ist zwischen einer Unterseite 7 der Hauptplatine 5 und der Bodenwand 4a ein deutlich geringerer erster Abstand Al, etwa im Bereich von 6 mm bis 8 mm, ausgebildet, als ein zweiter Abstand A2 zwischen einer Oberseite 8 der Hauptplatine 5 und der der Bodenplatte 4a gegenüberliegenden Deckelwand (nicht dargestellt in Figur 1).

Auf der Oberseite 8 und der Unterseite 7 sind mehrere elektrische und elektronische Komponenten wie ein oder mehrere Prozessoren, Regler, Kondensatoren und/oder andere Elemente angeordnet, die während eines Betriebs des Computersystems 1 Wärme erzeugen. Um diese Elemente zu kühlen, weist das Computersystem 1 ein passives und/oder aktives Kühlmanagement auf, wobei besonderes Augenmerk auf thermisch kritische Elemente zu legen gilt.

Um gerade im Spalt 6 angeordnete wärmeerzeugende Komponenten ausreichend zu kühlen, ist eine mögliche Ausgestaltung in Figur 2 gezeigt. In Figur 2 ist lediglich der in Figur 1 gezeigte Teil des Computergehäuses 2 gezeigt. Beispielhaft wird auf eine wärmeerzeugende Komponente 9 Bezug genommen, die auf der Unterseite 7 der Hauptplatine 5 angeordnet ist und in Figur 2 gestrichelt angedeutet ist. Um einen besonders guten Wärmeübergang von der wärmeerzeugenden Komponente 9 auf das Computergehäuse 2, im Beispiel die Bodenwand 4a, zu erreichen, ist an der Bodenwand 4a gegenüberliegend zu der wärmeerzeugenden Komponente 9 ein thermisch leitendes Pad 10 angeordnet. Bei solch einem Pad handelt es sich um ein wärmeleitendes Element wie eingangs erwähnt. Dieses Pad 10 koppelt die Komponente 9 thermisch mit der Bodenwand 4a, um eine mechanisch-thermische Kopplung, das heißt eine Wärmeleitung, auszubilden. Neben dem Pad 10 sind noch zwei weitere Pads 11 vorgesehen, die die Wärmeabfuhr von anderen Komponenten gleichermaßen begünstigen sollen. Die Anzahl und Anordnung der Pads 10, 11 sind für das Verständnis der Erfindung unbedeutend.

Jedes Pad 10, 11 muss einen vergleichsweise großen Abstand, maximal den ersten Abstand Al, zur Bodenwand 4a überbrücken, was sich negativ auf die Wärmeübertragung auswirkt. Je dicker ein Pad 10, 11, desto ineffizienter der Wärmeübertrag. Darüber hinaus steigen mit Zunahme der Dicke der Pads 10, 11 die Kosten pro Pad 10, 11.

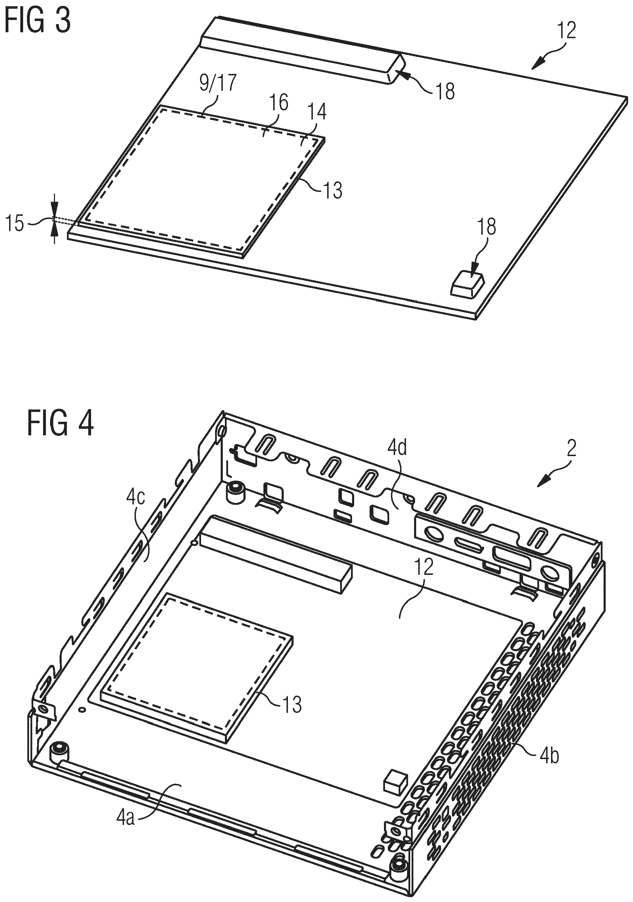

Figuren 3 und 4 zeigen ein verbessertes System, wobei in Figur 4 wiederum der in Figur 1 gezeigte Teil des Computergehäuses 2 dargestellt ist. Anstelle der vergleichsweise dicken Pads 10, 11 ist eine Wärmeverteilplatte 12 vorgesehen, die in einem Aluminiumdruckgussverfahren hergestellt ist. Es handelt sich demnach um einen Aluminiumdruckguss-Bauteil. Die Wärmeverteilplatte 12 erstreckt sich über den Großteil der Fläche der Bodenwand 4a. Die Wärmeverteilplatte 12 ist direkt in Kontakt mit der Bodenwand 4a, so dass eine besonders gute Wärmeleitung möglich ist.

Die Wärmeverteilplatte 12 hat einen Wärmeleitkörper 13, der flächig in Richtung der wärmeerzeugenden Komponente 9 hervorspringt. Mit anderen Worten handelt es sich bei dem Wärmeleitkörper 13 um einen massiven flächigen bzw. Quaderförmigen Vorsprung. Der Wärmeleitkörper 13 kann auch als Wärmeleitvorsprung bezeichnet werden. Der Wärmeleitkörper 13 ragt nah an die entsprechend zugeordnete wärmeerzeugende Komponente 9 (analog zu Figur 2 gestrichelt angedeutet) heran, wobei sich ein kleiner Spalt 15 zu der wärmeerzeugenden Komponente 9 ausbildet, etwa zwischen 0,5 mm bis 1,0 mm. Dieser Spalt wird mittels eines sehr dünnen Pads 14 überbrückt, um einen direkten Kontakt zu der wärmeerzeugenden Komponente 9 herzustellen. Das Pad 14 ist etwas dicker als zu überbrückende Spalt 15, beispielsweise 20 % dicker, um einen sicheren Anpressdruck zu gewährleisten.

Dadurch ist eine mechanisch thermische Kopplung der wärmeerzeugenden Komponente 9 mit einer Seitenwand des Computergehäuses 2 hergestellt, nämlich der Bodenwand 4a. Der Wärmeleitkörper 13 ist zudem in seiner Formgebung an die wärmeerzeugende Komponente 9 angepasst, d.h. eine Kontaktfläche 16 des Wärmeleitkörpers 13 bzw. des Pads 14 entspricht im Wesentlichen einer Gegenkontaktfläche 17 der wärmeerzeugenden Komponente 9. Beispielsweise ragt der Wärmeleitkörper 13 nicht über die äußeren Konturen der wärmeerzeugenden Komponente 9 hinaus, bezogen auf eine Haupterstreckungsebene der Seitenwand 4a oder der Hauptplatine 5.

Die Wärmeverteilplatte 12 mit integralen Wärmeleitkörper 13 ermöglicht die eingangs genannten Vorteile und Funktionen. Insbesondere kann das Pad 14 deutlich dünner als die zuvor beschriebenen Pads 10, 11 ausgebildet sein, was den Wärmeübergang deutlich verbessert. Darüber hinaus kann aufgrund des Druckgussverfahrens die Wärmeverteilplatte 12 besonders exakt und mit vergleichsweise großen Wandstärken gefertigt werden. Die Wandstärke der Wärmeverteilplatte 12 sind insbesondere dicker als die der zugeordneten Seitenwand, im Beispiel der Bodenwand 4a. Weiterhin wird eine Massenanhäufung durch den Wärmeleitkörper 13 erreicht, da dieser massiv ausgebildet ist. Dadurch kann zusätzliche thermische Energie aufgenommen und zu einer effizienten Kühlung des Computersystems 1 beigetragen werden.

Analog zu oben können weitere Wärmeleitkörper 18 für andere wärmeerzeugende Komponenten vorgesehen sein.

Optional kann auf die Platte 12 verzichtet sein und lediglich ein Wärmleitkörper 13 direkt mit der entsprechenden Seitenwand 4 verbunden werden.

Bei dem Ausführungsbeispiel wurde speziell die Wärmeabfuhr in dem Spalt 6, in dem beispielsweise bei aktivem Kühlsystem mittels Lüfter kaum Luftströmung gelangt, verbessert. Die Idee der Erfindung lässt sich problemlos auch auf die Kühlung von Komponenten auf der der Oberseite 8 der Hauptplatine 5 anwenden, wobei dann an die nicht gezeigte Deckelwand eine entsprechende Wärmeverteilplatte angebracht wird.

### BEZUGSZEICHENLISTE

- 1: Computersystem
- 2: Computergehäuse
- 3: Inneres
- 4: Seitenwand
- 4a: Bodenwand
- 4b: Seitenwand
- 4c: Seitenwand
- 4d: Seitenwand
- 5: Hauptplatine
- 6: Spalt
- 7: Unterseite
- 8: Oberseite
- 9: wärmeerzeugende Komponente
- 10: Pad
- 11: weiteres Pad
- 12: Wärmeverteilplatte
- 13: Wärmeleitkörper
- 14: dünnes Pad
- 15: Spalt
- 16: Kontaktfläche
- 17: Gegenkontaktfläche
- 18: weiterer Wärmeleitkörper

## Patentansprüche

1. Computersystem (1), aufweisend ein Computergehäuse (2) mit mehreren Seitenwänden (4), und eine in dem Computergehäuse (2) angeordnete Hauptplatine (5), auf der zumindest eine wärmeerzeugende Komponente (9) angeordnet ist, wobei eine Seitenwand (4a) des Computergehäuses (2), die der wärmeerzeugenden Komponente (9) zugewandt ist, einen Wärmeleitkörper (13) aufweist, der in Richtung der wärmeerzeugenden Komponente (9) vorspringt, wobei der vorspringende Wärmeleitkörper (13) integraler Teil Z. einer der Wärmeverteilplatte (12) und mit dieser einstückig ausgebildet ist, wobei die Wärmeverteilplatte (12) an der entsprechenden Seitenwand (4a) angeordnet ist, und wobei der Wärmeleitkörper (13) und die Wärmeverteilplatte (12) als Aluminiumdruckgussbauteil ausgebildet sind, und der Wärmeleitkörper (13) ausgebildet ist, mittels Wärmeleitung Wärmeenergie der wärmeerzeugenden Komponente (9), die während eines bestimmungsgemäßen Betriebs entsteht, aufzunehmen und mittels Wärmeleitung in die entsprechende Seitenwand (4a) abzuführen.

2. Computersystem (1) nach Anspruch 1, wobei der Wärmeleitkörper (13) in direktem Kontakt mit der wärmeerzeugenden Komponente steht.

3. Computersystem (1) nach Anspruch 1, wobei zwischen dem Wärmeleitkörper (13) und der wärmeerzeugenden Komponente ein Spalt (15) ausgebildet ist, in welchem ein wärmeleitendes Element angeordnet ist, so dass der Wärmeleitkörper (13) mittels des wärmeleitenden Elements mittelbar mit der wärmeerzeugenden Komponente (9) in Kontakt steht.

4. Computersystem (1) nach einem der vorhergehenden Ansprüche, wobei der Wärmeleitkörper (13) im Vergleich zu der entsprechenden Seitenwand (4a) eine größere Wandstärke aufweist.

5. Computersystem (1) nach einem der vorhergehenden Ansprüche, wobei der Wärmeleitkörper (13) hinsichtlich einer Formgebung an die wärmeerzeugende Komponente (9) angepasst ist.

6. Computersystem (1) nach einem der vorhergehenden Ansprüche, wobei die Hauptplatine (5) an der entsprechenden Seitenwand (4a) des Computersystems (1) angeordnet ist und ein Spalt (6) zwischen der Seitenwand (4a) und der Hauptplatine (5) ausgebildet ist, in welchem die wärmeerzeugende Komponente (9) angeordnet ist.

7. Computersystem (1) nach einem der vorhergehenden Ansprüche, wobei die Wärmeverteilplatte (12) sich über mehr als die Hälfte der Fläche der entsprechenden Seitenwand (4a) erstreckt.

8. Wärmeleitkörper (13) und Wärmeverteilplatte (12) für ein Computersystem (1) nach einem der Ansprüche 1 bis 7, die ausgebildet sind, an einer Seitenwand (4a) eines Computergehäuses (2) des Computersystems (1) angeordnet zu werden, so dass der Wärmeleitkörper (13) in Richtung einer wärmeerzeugenden Komponente (9) einer Hauptplatine (5) des Computersystems (1) vorspringt, wobei der Wärmeleitkörper (13) integraler Teil der Wärmeverteilplatte (12) und mit dieser einstückig ausgebildet ist und wobei der Wärmeleitkörper (13) und die Wärmeverteilplatte (12) als Aluminiumdruckgussbauteil ausgebildet sind, und der Wärmeleitkörper (13) ausgebildet ist, Wärme der wärmeerzeugenden Komponente (9), die während eines bestimmungsgemäßen Betriebs des Computersystems (1) entsteht, mittels Wärmeleitung in die Seitenwand (4a) abzuführen.

## Claims

1. A computer system (1), comprising
a computer casing (2) having a plurality of side panels (4), and a main board (5) disposed in the computer casing (2) and having at least one heat generating component (9) disposed thereon, wherein a side wall (4a) of the computer casing (2) facing the heat generating component (9) has a heat conductive body (13) projecting toward the heat generating component (9), the projecting heat conductive body (13) being an integral part of and integrally formed with a heat distribution plate (12), wherein the heat distribution plate (12) is arranged on the corresponding side wall (4a), and wherein the heat conductive body (13) and the heat distribution plate (12) are formed as a die-cast aluminum component, and the heat conductive body (13) is designed to absorb, by means of heat conduction, heat energy of the heat-generating component (9) which is generated during an intended operation, and to dissipate it into the corresponding side wall (4a) by means of heat conduction.

2. The computer system (1) according to claim 1,
wherein the heat conductive body (13) is in direct contact with the heat generating component.

3. The computer system (1) according to claim 1, wherein a gap (15) is formed between the heat conductive body (13) and the heat generating component, in which gap a heat conducting element is arranged so that the heat conductive body (13) is indirectly in contact with the heat generating component (9) by means of the heat conducting element.

4. The computer system (1) according to any one of the preceding claims, wherein the heat conductive body (13) has a greater wall thickness compared to the corresponding side wall (4a).

5. The computer system (1) according to any one of the preceding claims, wherein the heat conductive body (13) is adapted to the heat generating component (9) with respect to a shaping.

6. The computer system (1) according to any one of the preceding claims, wherein the main board (5) is arranged on the corresponding side wall (4a) of the computer system (1) and a gap (6) is formed between the side wall (4a) and the main board (5) in which the heat generating component (9) is arranged.

7. The computer system (1) according to any one of the preceding claims, wherein the heat distribution plate (12) extends over more than half of the area of the corresponding side wall (4a).

8. A heat conductive body (13) and a heat distribution plate (12) for a computer system (1) according to any one of claims 1 to 7, which are adapted to be arranged on a side panel (4a) of a computer casing (2) of the computer system (1) so that the heat conductive body (13) projects toward a heat generating component (9) of a main board (5) of the computer system (1), wherein the projecting heat conductive body (13) is an integral part of and integrally formed with a heat distribution plate (12), and wherein the heat conductive body (13) and the heat distribution plate (12) are formed as a die-cast aluminum component, and the heat conductive body (13) is designed to dissipate heat of the heat generating component (9), which is generated during an intended operation of the computer system (1), into the side wall (4a) by means of heat conduction.

## Revendications

1. Système d'ordinateur (1), présentant
un boîtier d'ordinateur (2) comportant plusieurs parois latérales (4), et une carte mère (5) disposée dans le boîtier d'ordinateur (2), sur laquelle au moins un composant (9) générateur de chaleur est disposé, sachant qu'une paroi latérale (4a) du boîtier d'ordinateur (2) qui est tournée vers le composant (9) générateur de chaleur présente un corps thermoconducteur (13) qui fait saillie en direction du composant (9) générateur de chaleur, sachant que le corps thermoconducteur (13) faisant saillie fait partie intégrante d'une plaque de distribution thermique (12) et est constitué d'une seule pièce avec celle-ci, sachant que la plaque de distribution thermique (12) est disposée au niveau de la paroi latérale (4a) correspondante, et sachant que le corps thermoconducteur (13) et la plaque de distribution thermique (12) sont constitués comme élément en aluminium moulé sous pression, et le corps thermoconducteur (13) est constitué pour absorber par conduction thermique de l'énergie thermique du composant (9) générateur de chaleur qui est produite pendant un fonctionnement conforme à l'usage prévu et pour l'évacuer par conduction thermique vers la paroi latérale (4a) correspondante.

2. Système d'ordinateur (1) selon la revendication 1, sachant que le corps thermoconducteur (13) est en contact direct avec le composant générateur de chaleur.

3. Système d'ordinateur (1) selon la revendication 1, sachant qu'une fente (15) dans laquelle un élément thermoconducteur est disposé est constituée entre le corps thermoconducteur (13) et le composant générateur de chaleur de telle sorte que le corps thermoconducteur (13) soit indirectement en contact avec le composant (9) générateur de chaleur moyennant l'élément thermoconducteur.

4. Système d'ordinateur (1) selon l'une des revendications précédentes, sachant que le corps thermoconducteur (13) présente une épaisseur de paroi plus grande en comparaison avec la paroi latérale (4a) correspondante.

5. Système d'ordinateur (1) selon l'une des revendications précédentes, sachant que le corps thermoconducteur (13) est adapté au composant (9) générateur de chaleur en termes de façonnage.

6. Système d'ordinateur (1) selon l'une des revendications précédentes, sachant que la carte mère (5) est disposée au niveau de la paroi latérale (4a) du système d'ordinateur (1) et une fente (6) dans laquelle le composant (9) générateur de chaleur est disposé est constituée entre la paroi latérale (4a) et la carte mère (5).

7. Système d'ordinateur (1) selon l'une des revendications précédentes, sachant que la plaque de distribution thermique (12) s'étend sur plus de la moitié de la surface de la paroi latérale (4a) correspondante.

8. Corps thermoconducteur (13) et plaque de distribution thermique (12) pour un système d'ordinateur (1) selon l'une des revendications 1 à 7, qui sont constitués pour être disposés au niveau d'une paroi latérale (4a) d'un boîtier d'ordinateur (2) du système d'ordinateur (1) de telle sorte que le corps thermoconducteur (13) fasse saillie en direction d'un composant (9) thermoconducteur d'une carte mère (5) du système d'ordinateur (1), sachant que le corps thermoconducteur (13) fait partie intégrante de la plaque de distribution thermique (12) et est constitué d'une seule pièce avec celle-ci et sachant que le corps thermoconducteur (13) et la plaque de distribution thermique (12) sont constitués comme élément en aluminium moulé sous pression, et le corps thermoconducteur (13) est constitué pour évacuer, par conduction thermique, de la chaleur du composant (9) générateur de chaleur qui est produite pendant un fonctionnement conforme à l'usage prévu du système d'ordinateur (1) vers la paroi latérale (4a).
